(19) Europäisches Patentamt / European Patent Office / Office européen des brevets

(11) **EP 4 456 419 A1**

(12) **EUROPEAN PATENT APPLICATION**

(43) Date of publication:
**30.10.2024 Bulletin 2024/44**

(21) Application number: **23170711.8**

(22) Date of filing: **28.04.2023**

(51) International Patent Classification (IPC):
**H03F 1/02** *(2006.01)*    **H03F 3/19** *(2006.01)*
**H03F 3/21** *(2006.01)*    **H03F 3/24** *(2006.01)*
**H03F 3/60** *(2006.01)*

(52) Cooperative Patent Classification (CPC):
**H03F 1/0288; H03F 3/19; H03F 3/211; H03F 3/245;**
**H03F 3/602;** H03F 2200/192; H03F 2200/222;
H03F 2200/318; H03F 2200/387; H03F 2200/451;
H03F 2203/21103; H03F 2203/21139

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Infineon Technologies AG**
**85579 Neubiberg (DE)**

(72) Inventors:
• **BAUDER, Ruediger**
  **83052 Bruckmühl (DE)**
• **SHIROKOV, Mikhail**
  **80804 München (DE)**

(74) Representative: **König, Andreas Rudolf et al**
  **Schoppe, Zimmermann, Stöckeler**
  **Zinkler, Schenk & Partner mbB**
  **Patentanwälte**
  **Radlkoferstraße 2**
  **81373 München (DE)**

(54) **INVERTED DOHERTY-TYPE AMPLIFIER DEVICE**

(57) An inverted Doherty-type amplifier device comprises a distribution network comprising a first signal port for providing a first signal for a main path of the inverted Doherty-type amplifier from a received input signal and a second signal port for providing a second signal for a peak path of the inverted Doherty-type amplifier device from the received input signal. The device comprises a first amplifier coupled in the main path and coupled to the first signal port, configured to amplify a received signal to obtain a first amplified signal. The device comprises a first phase correction network coupled to the second signal port and coupled to adjust a phase of a received signal to obtain a phase corrected second signal. A second amplifier is coupled to an output of the first phase correction network and is configured to amplify a received signal to obtain a second amplified signal. A second phase correction network is coupled to an output for the second amplifier and configured to adjust a phase of a received signal to obtain a phase corrected second amplified signal. A signal combiner has a first input coupled to an output of the first amplifier and a second input coupled to an output of the second phase correction network, the signal combiner configured to combine a signal that is based on the first amplified signal and a signal that is based on the phase corrected second amplified signal to obtain a combined signal.

Fig. 1

EP 4 456 419 A1

**Description**

The present disclosure relates to an inverted Doherty-type amplifier device and to a method for amplifying a signal. The present disclosure in particular relates to a cascaded dual driver or multi-driver Doherty power amplifier.

Power amplifiers allow to amplify a signal. An example of such a power amplifier is a Doherty-type power amplifier and an inverted Doherty-type power amplifier. Those amplifiers comprise a main path for amplifying a signal and a peak path to amplify portions of the signal will exceed an amplitude threshold. As those scenarios are expected to be rare, an operation of amplifying components may be restricted in time to time instances where needed.

Such power amplifiers are used in antenna arrays of 5G infrastructure base stations.

It is an object of the present disclosure to provide for enhancements of power amplifier devices, in particular, inverted Doherty-type power amplifier devices. It is an object to improve methods for amplifying a signal.

According to an embodiment, an inverted Doherty-type amplifier device comprises a distribution network comprising a first signal port for providing a first signal for a main path of the inverted Doherty-type amplifier from a received input signal. The distribution network comprises a second signal port for providing a second signal for a peak path of the inverted Doherty-type amplifier device from the received input signal. The inverted Doherty-type amplifier device comprises a first amplifier coupled in the main path and coupled to the first signal port, configured to amplify a received signal to obtain a first amplified signal. A first phase correction network is coupled to the second signal port and configured to adjust a phase of a received signal to obtain a phase corrected second signal. A second amplifier of the inverted Doherty-type amplifier device is coupled to an output of the first phase correction network and configured to amplify a received signal to obtain a second amplified signal. A second phase correction network is coupled to an output of the second amplifier and is configured to adjust a phase of a received signal to obtain a phase corrected second amplified signal. A driver circuit is coupled in the peak path, wherein the first phase correction network is adapted to at least partially compensate for a phase shift caused by the driver circuit. A signal combiner of the inverted Doherty-type amplifier device has a first input coupled to an output of the first amplifier and has a second input coupled to an output of the second phase correction network. The signal combiner is configured to combine a signal that is based on the first amplified signal and a signal that is based on the phase corrected second amplified signal to obtain a combined signal.

According to an embodiment, a method for amplifying a signal comprises providing a first signal for a main path of an inverted Doherty-type amplifier from a received input signal. The method comprises providing a second signal for a peak path of the inverted Doherty-type amplifier device from the received input signal. The method comprises amplifying a signal that is based on the first signal to obtain a first amplified signal and comprises adjusting a phase of a signal that is based on the second signal to obtain a phase corrected second signal. The method comprises amplifying a signal that is based on the phase corrected second signal to obtain a second amplified signal. The method comprises adjusting a phase of a signal that is based on the second amplified signal to obtain a phase corrected second amplified signal. The method comprises at least partially compensating a phase shift caused by a driver circuit in the peak path with a phase correction network. A signal that is based on the first amplified signal and a signal that is based on the phase corrected second amplified signal is combined to obtain a combined signal.

Advantageous embodiments of the present disclosure are defined in the dependent claims.

Embodiments in accordance with the present disclosure are described hereinafter while making reference to the accompanying drawings in which:

Fig. 1      shows a schematic block diagram of an inverted Doherty-type amplifier device according to an embodiment;

Fig. 2      shows a schematic block diagram of an inverted Doherty-type amplifier device according to an embodiment; having parasitic capacitance and inductance ele-ments;

Fig. 3a-f      show schematic block diagrams of distribution networks that may be used in embodiments described herein;

Fig. 4      shows a schematic table to illustrate example split ratios of distribution networks according to embodiments;

Fig. 5      shows again the inverted Doherty-type amplifier device illustrated in Fig. 1 and shows phase planes that may be identified in the circuitry;

Fig. 6a-i      show schematic block diagrams of implementations of three-way inverted Doherty-type amplifier devices according to embodiments

Fig. 7      represents an example table of possible split ratios between two peak paths of a three-way inverted Doherty-type amplifier device according to an embodiment; and

Fig. 8      shows a schematic block diagram of a method according to an embodiment.

Equal or equivalent elements or elements with equal or equivalent functionality are denoted in the following description by equal or equivalent reference numerals even if occurring in different figures.

In the following description, a plurality of details is set forth to provide a more thorough explanation of embodiments of the present disclosure. However, it will be apparent to those skilled in the art that embodiments of the present disclosure may be practiced without these specific details. In other instances, well known structures and devices are shown in block diagram form rather than in detail in order to avoid obscuring embodiments of the present disclosure. In addition, features of the different embodiments described hereinafter may be combined with each other, unless specifically noted otherwise.

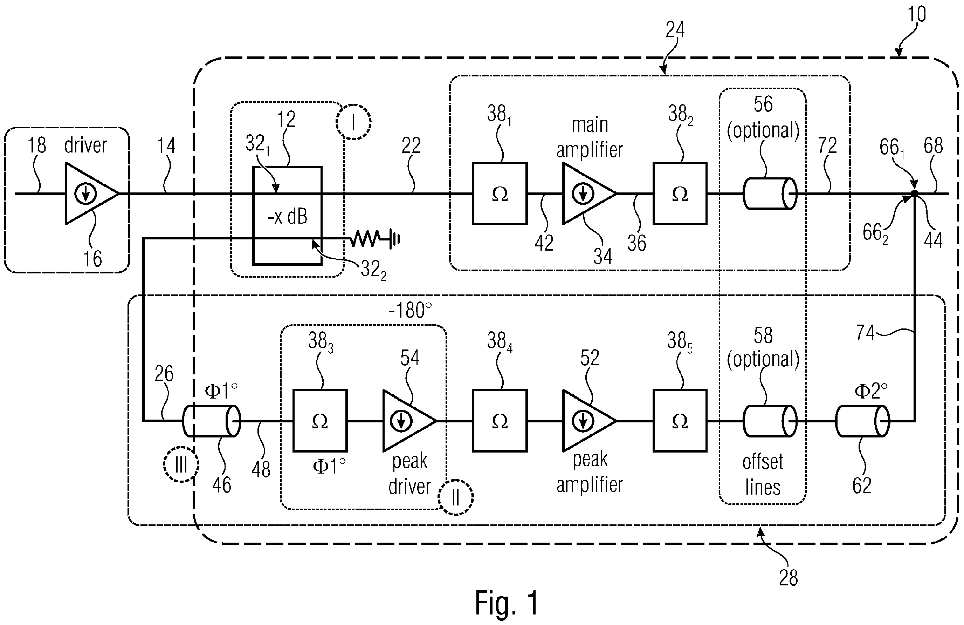

Fig. 1 shows a schematic block diagram of an inverted Doherty-type amplifier device 10 according to an embodiment. The inverted Doherty-type amplifier device 10 comprises a distribution network 12, e.g., comprising a coupler and/or a splitter adapted to receive an input signal 14, the input signal 14 to be amplified. For example, the input signal 14 may be provided by or received from an optional driver 16 amplifying a signal 18 having an input power level $P_{in}$. However, this is optional and the distribution network 12 may also receive an unamplified signal. The distribution network 12 is adapted for providing at least two signals 22 and 24 as an output from the received input signal 14. For example, a signal 22 may be provided for a main path 24 of the inverted Doherty-type amplifier device and a signal 26 may be provided for a peak path 28 of the inverted Doherty-type amplifier device. The distribution network 12 may comprise signal ports $32_1$, $32_2$ for providing the signal 22, 26, respectively. An amplifier 34 is coupled in the main path 24 and is coupled to the signal port $32_1$. The amplifier 34 is configured to amplify a received signal, e.g., signal 22 to obtain an amplified signal 36. For example, the amplifier 34 may be operated as a class AB amplifier.

For example, the distribution network 12 may comprise one of an unequal lumped Wilkinson splitter, a lumped coupler and a lumped hybrid coupler. Different phase changes of output signals provided by those elements may be considered and compensated by use of the phase correction networks 46 and 62.

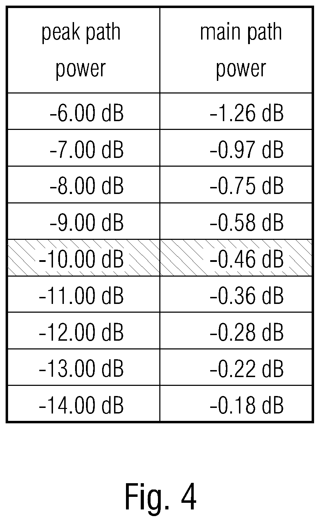

According to an embodiment, the distribution network 12 may be configured to provide the signal 22 having a gain in the main path of at least -1.25 dB and at most -0.5 dB according to a planned or implemented MAIN/PEAK split ratio. Within said embodiment, the signal 26 is provided by the distribution network 12 a gain in the main path of at least -14 dB and at most -6 dB according to a planned or implemented MAIN/PEAK split ratio as indicated, for example, in Fig. 4, wherein any split ratio may be implemented without leaving the scope of the embodiments.

An input matching network 38, may be coupled between the distribution network 12 and the power amplifier 34. Alternatively, other circuitry may be coupled between the amplifier 34 and the signal port $32_1$, each configuration leading to a scenario in which a signal 42 that is amplified by the amplifier 34 is based on the signal 22.

In connection with embodiments described herein, there are described signals that are based on one or more other signals. Such a signal being based on one or more other signals may be understood as having the option but not the requirement to have additional circuit elements coupled therebetween within the scope of non-inverted Doherty-type amplifier devices. That is, such a signal that is based on another signal may be the other signal itself or may be a modified version thereof, e.g., modified due to a phase shift, an amplification or the like.

For example, an input matching network $38_2$ may be effective between an output of the amplifier 34 and a combiner 44.

Switching to the peak path 28, same comprises a phase correction network 46 coupled to the signal port $32_2$, i.e., directly or comprising intermediate components, and configured to adjust a phase of a received signal, e.g., signal 26, to obtain a phase corrected second signal 48. Input matching networks $38_3$ are illustrated as a single block between the phase correction network 46 and an amplifier 52 of the peak path 28. However, such a network may also be located elsewhere and/or as a distributed component. Same applies to other matching networks described herein, e.g., input matching networks 38, and/or $38_2$. According to an embodiment, the amplifier 52 may be operated as a class C amplifier.

The peak path 28 may comprise a driver circuit 54 to pre-amplify the signal 26, the phase corrected signal 48, respectively, for the amplifier 52. The driver circuit 54 may be referred to as peak driver. The driver circuit 54 may allow to compensate for a gain difference between power that is obtained in some embodiments where more power is assigned to signal 22 when compared to signal 26, i.e., where an unequal power distribution is implemented. In other words, embodiments are based on the recognition, that it is of benefit to use an unequal power distribution, e.g., by implementing the distribution network 12 as an unequal or asymmetric Wilkinson splitter or the like to provide a comparable high power to the main path. Such low power in the peak path may be compensated by use of the driver circuit 54, the phase shift thereof to be compensated, at least in parts, by using the phase correction network 46. Such a topology may also be useful for an equal or symmetric power distribution, if implemented. Such a gain difference between the input coupler main path 24 and the peak path 28. The matching network $38_3$ and the driver circuit 54 may be designed with respect to a phase behavior in the main path 24 in order to keep a phase dispersion over frequency and RF envelope between the main path 24 and the peak path 28 as small as possible or equal within a tolerance range.

An offset line 56 may be coupled in the main path 24 between the amplifier 34 and the combiner 44. Alternatively or in addition, offset lines 58 may be coupled between the amplifier 52 and the combiner 44. Besides those optional elements the peak path 28 comprises a phase correction network 62 coupled to an output of the amplifier 52 and configured to adjust a phase of a received signal, i.e., the output of amplifier 52, of the illustrated input matching network $38_5$ or of the optional offset lines 58. The phase correction network 62 may provide for a phase corrected second amplified signal 64 that is provided to the signal combiner that has at least two inputs $66_1$ and $66_2$, input $66_1$ coupled to an output of the amplifier 34 and input $66_2$ coupled to an output of amplifier 52.

The phase correction network 62 may be configured to provide a phase shift of essentially 90°, i.e., within a tolerance range of ±20°, ±10°, ±5° or ±2°. Phase correction networks 56, 58 and 62 may be set to loadpull the amplifier 34, such that the phase correction network 62 may have, according to a possible but not limiting implementation, a phase shift in the range of 90° ± the mentioned tolerances. This may be adapted to the phase shifts of the respective driver or amplifier circuits that may provide for a phase shift of essentially 180°. That is, based on differences in other circuit elements, phase correction networks 46 and/or 62 may provide for other phase shifts so as to compensate for phase deviations and to obtain a phase correction of signal 74 with regard to signal 72.

The signal combiner may comprise a passive component, e.g., an electrically conductive connection that may also comprise an active component. The signal combiner 44 is configured to combine the signals being based on amplifiers 34 and 52 to obtain a combined signal 68 that has an output power $P_{out}$.

The presented structure allows a phase correction provided by phase correction network 46 to be obtained in the peak path 28 that is adapted to be switched off or deactivated during some instances of time, such that an energy loss received by adapting the phase with the phase correction network 46 may be avoided during those instances in time.

Although being illustrated as two distinct elements, the offset lines 58 and the phase correction network 62 may be implemented with a single phase correction network 62.

A signal 72 that is based on the first amplified signal 36 and coupled to the input $66_1$ and a signal 74 that is provided by the phase correction network 62 comprise a same phase, at least within a tolerance range.

When considering an ideal Doherty-type power amplifier (DPA), the main amplifier and the peak amplifier may operate as ideal intrinsic amplifiers. Both amplifiers may act as current sources. In order to maintain the intrinsic main amplifier close to a voltage compression, the intrinsic peak amplifier may be transformed to a voltage source at the intrinsic main amplifier terminal through an impedance inverter, e.g., with a 90° transmission line. When the peak amplifier switches on for high RF envelope signals, the main amplifier may operate into a lower impedance. Both peak and main amplifier may provide for a power into the output ($P_{out}$) with maintaining voltage compression for the main amplifier. That measure maintains high efficiency. In order to maintain a coherent phase front of the RF envelope, the signal to the peak amplifier input is to be delayed by 90°.

When considering a real Doherty-type power amplifier, the main amplifier and the peak amplifier operate as amplifiers with parasitics, e.g., the Drain-Source (collector-emitter for bipolar transistors) capacitance Cm and Cp. The connection from the drain (collector) to output network is inductive, realized with wire bonds in most applications for wireless infrastructure. Cm and Lm and Lp, respectively, may form a phase shift between the main and the peak amplifier which would destroy the Doherty loading criteria. Therefore, these parasitic elements are extended with an offset line to form a λ/2 (180°) rotation to maintain the Doherty power amplifier loading criteria. A possible drawback with regard to a negative impact on bandwidth and post power amplifier insertion losses is addressed with the present embodiments. An inverter Doherty-type power amplifier is based on a concept according to which the offset line is extending the phase shifts introduced by Cm, Lm/Cp, Lp to a λ/4 (90°) impedance inverter line, that has a lower loss and less phase dispersion over frequency (i.e., high BW) compared to a traditional Doherty power amplifier and still maintains the dynamic load seen from the main amplifier terminal. In order to make this concept to operate with coherent RF waveforms, the 90° delay element and the peaking amplifier input of the regular Doherty power amplifier is moved to the input path of the main amplifier.

The distribution network 12 allows for a low insertion loss, IL, between driver 16 and amplifier 34 resulting in a relaxed requirement to the driver 16 to provide RF power. The IL may be adjusted, in embodiments described herein, in a range of approximately 1 dB ± 0.5 dB. The driver circuit 54 may compensate for effects, e.g., of a class C peak amplifier gain drop caused by the operation of amplifier 52 and/or of coupling losses. The peak driver 54 and the distribution network, e.g., coupler, 12 implementing a high coupling ratio, may isolate the peak output to the main output. Due to the phase inversion of the driver circuit 54, the input delay line 46 provides for additional benefits in the peak path as it less sensitive on power-added efficiency, PAE, e.g., in the Doherty driver. Such a circuitry may provide for a gain advantage when compared to a known Doherty-type power amplifier of about 3 dB. Although there might be generated additional power dissipation by the additional peak driver, the gain obtained thereby overrule said advantage as the power dissipation only occurs when powering the peak path.

Embodiments relate, for example, to RF systems, e.g., radio heads or the like, that comprise one or more inverted Doherty-type amplifier devices as described herein.

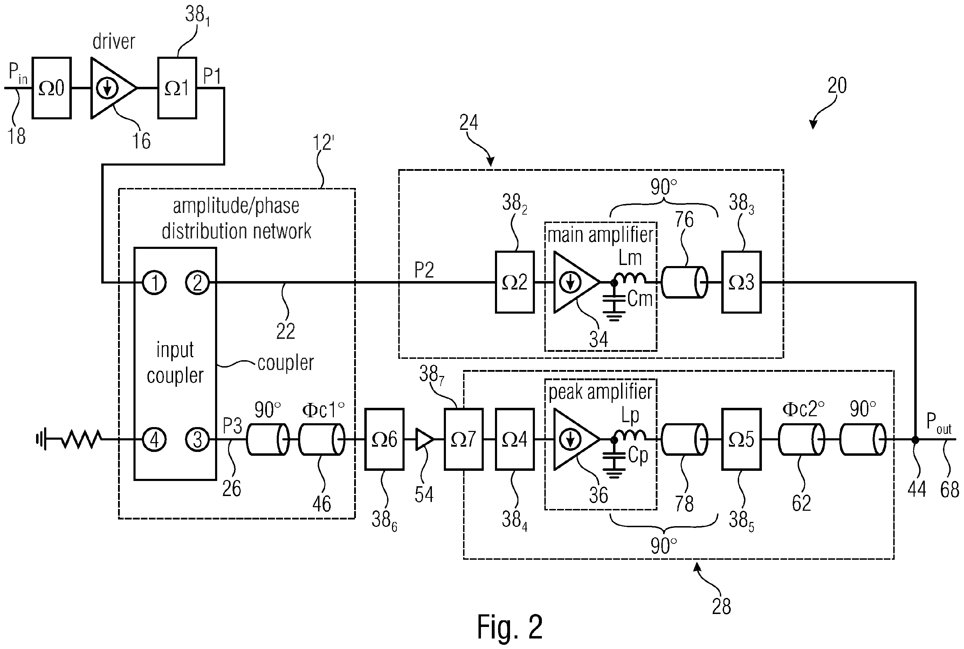

Fig. 2 shows a schematic block diagram of an inverted Doherty-type amplifier device 20 according to an embodiment. Therein, the above-mentioned parasitics Cm and Lm representing a capacitance and an induction of the main path 24 are illustrated as well as an inductance Lp and a capacitance Cp effective in the peak path 28. Further, above-mentioned offset lines 76 coupled to an output of the main amplifier 34 and offset lines 78 coupled to an output of the peak amplifier 36 are shown to arrive at a phase shift of 90° each.

When compared to the Doherty-type amplifier device 10, a distribution network 12' may already include the phase correction network 46. The distribution network 12' may comprise a coupler to provide the signals 22 and 26 for the main path 24 and the peak path 28, respectively. For example, based on the realized implementation, the distribution network 12' may, according to one embodiment, comprise a coupler with an inherent phase shift of 90° (e.g., 90°-hybrid) such that the illustrated 90° line can be avoided. According to another embodiment, the distribution network 12' may comprise an equal phase coupler (e.g., a Wilkinson coupler) leading to advantages of using the 90° shift line.

In Fig. 2, $\Phi c1°$ of phase correction network 46 may indicate a correction of a phase with a positive or negative sign, e.g., absorbed by a 90° line. Alternatively or in addition $\Phi c2°$ of phase correction network 62 may indicate a correction of a phase with a positive or negative sign, e.g., absorbed by a 90° line. Alternatively or in addition Cm may relate to an intrinsic Drain-Source (Collector-Emitter) Capacitance of the main amplifier transistor and/or Lm may indicate an intrinsic wirebond inductance Drain-Output (Collector-Output) of main amplifier transistor. Alternatively or in addition, Cp may relate to an intrinsic Drain-Source (Collector-Emitter) Capacitance of the peak amplifier transistor and/or Lp may indicate an intrinsic wirebond inductance Drain-Output (Collector-Output) of peak amplifier transistor.

Matching networks $38_6$ and $38_7$ may match a phase of the driver circuit 54, however, e.g., networks $38_4$ and $38_7$ may form, at least in parts, a common network such that the illustrated blocks may be considered as functional blocks that may be combined to a common circuitry.

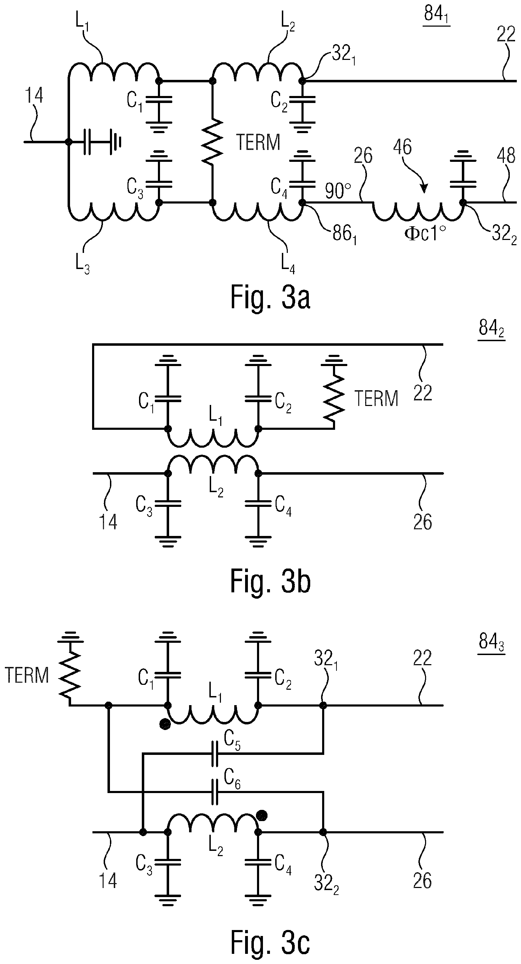

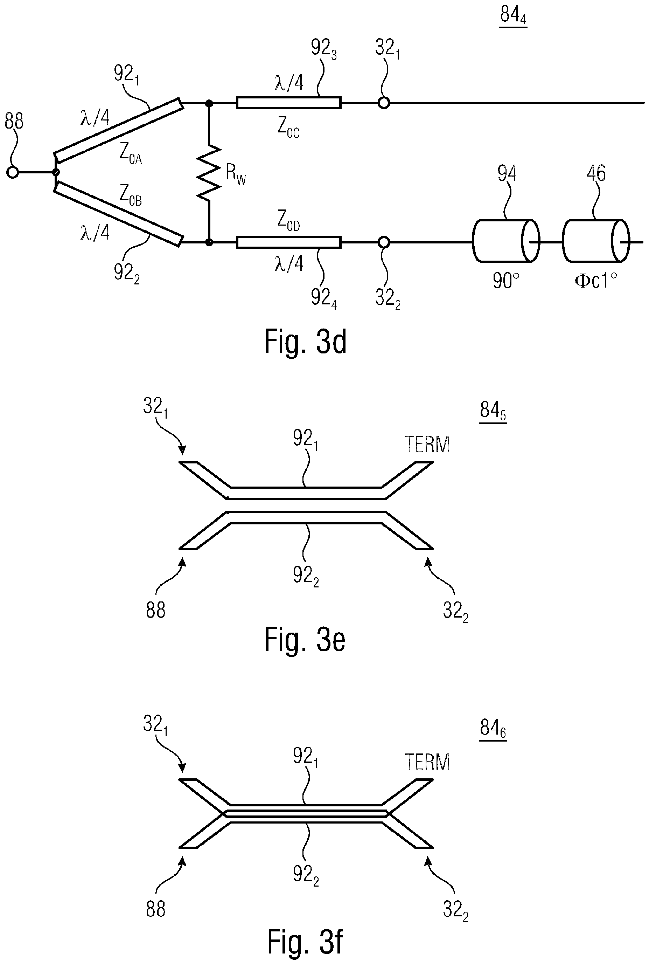

Fig. 3a shows a schematic block diagram of a distribution network 48, that may be used as distribution network 12 and/or 12' in embodiments described herein. Distribution network $48_1$ may be implemented as an unequal lumped Wilkinson splitter in which, based on a design and/or layout of inductances $L_1$, $L_2$, $L_3$ and/or $L_4$ as well as capacitances $C_1$, $C_2$, $C_3$ and/or $C_4$, a ratio between output powers delivered at ports $32_1$ and $32_2$ may be adjusted, e.g., to be unequal, for example, within the split ratios described herein. Optionally, as shown in Fig. 3, a 90° phase shift provided at node $86_1$ may be compensated by use of phase correction network 46 to provide the phase corrected signal already at port $32_2$. Whether the phase correction network 46 is part of the distribution network or coupled externally to the distribution network 84, may be up to implementation.

Fig. 3b shows a schematic block diagram of a distribution network $84_2$ that may be used in a Doherty-type amplifier device described herein. The distribution network $84_2$ may be implemented as a lumped coupler comprising a respective arrangement of inductances $L_1$, $L_2$ and capacitances $C_1$ to $C_4$.

Fig. 3c shows a schematic block diagram of a distribution network $84_3$ that may be used in a Doherty-type amplifier device described herein. Distribution network $84_3$ may be implemented as a lumped hybrid coupler.

Fig. 3d shows a schematic block diagram of a distribution network $84_4$ according to an embodiment that may be used in a Doherty-type amplifier device according to an embodiment. Therein, an input port 88 may be configured to receive the input signal 14. To the input port 88, there may be connected delay lines 92, having a complex impedance $Z_{0A}$, to provide for a phase shift of $\lambda/4$ and, parallel hereto, a delay line $92_2$ having a complex impedance $Z_{0B}$ to also provide for a phase shift of $\lambda/4$. A resistor Rw may be coupled between ports of delay lines $92_1$ and $92_2$ that are distant from the input port 88. Further, a delay line $92_3$ may be coupled serially to the delay line $92_1$ and may be configured for a phase shift of $\lambda/4$. Similarly, a delay line $92_4$ may be coupled serially to delay line $92_2$ and may also provide for a phase shift of $\lambda/4$. The resistor $R_W$ may comprise two ports, a first port coupled between delay lines $92_1$ and $92_3$ and the other port coupled between delay lines $92_2$ and $92_4$.

Complex impedance values $Z_{0A}$, $Z_{0B}$, $Z_{0C}$ and/or $Z_{0D}$ of the distribution network $84_4$ may be designed in any suitable way. For example, one possible implementation may be represented based on the following determination rules:

$$Z_{0A} = Z_0 \times \left( \left( \frac{P_A}{P_B} \right)^{-1.5} + \left( \frac{P_A}{P_B} \right)^{-0.5} \right)^{0.5}$$

$$Z_{0B} = Z_0 \times \left( 1 + \frac{P_A}{P_B} \right)^{0.5} \left( \frac{P_A}{P_B} \right)^{0.25}$$

$$Z_{0c} = Z_0 \times \left( \frac{P_A}{P_B} \right)^{-0.25}$$

(continued)

$$Z_{0D} = Z_0 \times \left(\frac{P_A}{P_B}\right)^{0.25}$$

$$R_W = Z_0 \times \left(\left(\frac{P_A}{P_B}\right)^{0.5} + \left(\frac{P_A}{P_B}\right)^{-0.5}\right)$$

with $Z_0$ being a characteristic impedance of the coupler, the distribution network $84_4$ respectively. $P_A$ may indicate a power delivered at port 32, and $P_B$ indicates a signal power delivered at port $32_2$ from an input power $P_{IN}$ received at port 88. Example split ratios are shown in Fig. 4, wherein the illustrated table shows a respective associated power for the main path based on a peak path power. Those values are example values only, and should not limit the embodiments described herein. Other values for the peak path power and, responsive hereto, for the main path power or vice versa may be implemented without effecting the scope of the underlying disclosure.

An additional phase shift 94 may be coupled to signal port $32_2$, wherein the phase shifter 94 may also be coupled internally or prior to the signal port $32_2$ as well as the phase correction network 46. It is to be noted that the phase shifts obtained by phase shifter 94 and the phase correction network 46 may be combined by the phase correction network 46 such that the 90° phase shift of Fig. 2 is optional.

Same is true for phase correction network 62 in Fig. 2 that may also incorporate subsequent phase shift elements.

Fig. 3e shows a schematic block diagram of a distribution network $84_5$ being implemented as a coupler that comprises two delay lines 92, and $92_2$.

Fig. 3f shows a schematic block diagram of a distribution network $84_6$ according to an embodiment that may be used in a Doherty-type amplifier device as distribution network $84_5$. The distribution network $84_6$ may be formed as a hybrid coupler.

That is, the distribution network 12 or 12' may be implemented in different ways, e.g., based on a specific requirement, e.g., based on a required split ratio and/or frequency behaviors.

By implementing the embodiments described herein, it is possible to provide more split up power to the main amplifier input when compared to the peak amplifier input. Alternatively or in addition, embodiments allow to compensate a required increase of input power to the peak path by adding the optional dedicated driver for the peak path, e.g., driver circuit 54 shown in Fig. 1. A phase inversion caused thereby may also be compensated for with the phase compensation network, PCN, 46 that is shifted, when compared to a known inverted Doherty-type amplifier, from the main path to the peak path.

Embodiments of the present disclosure may provide for a Doherty-type amplifier device that may operate with 3-4 dB increased gain when compared to a single driver inverted Doherty-type amplifier device. This may result in a driver amplifier that has to provide the mentioned 3-4 dB less power when compared to known devices and has thus a high line up efficiency.

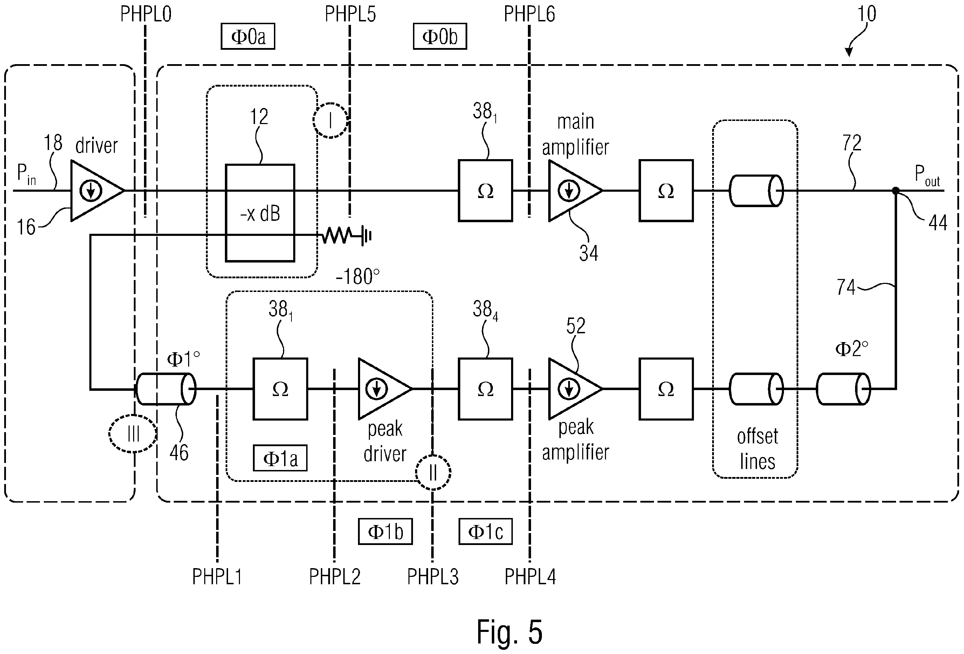

Fig. 5 shows again the inverted Doherty-type amplifier device 10 illustrated in Fig. 1 and shows phase planes PHPL0 through PHPL6 that may be identified in the circuitry. In the following, there are presented a set of correlations of phase deviations or phase shifts caused or compensated by a single element to indicate that a variation in one of the circuitry elements described herein may be compensated by a variation in another component to maintain the requirement that at the output, e.g., the combiner 44, an essentially same phase of signals 72 and 74 is applied. According to an embodiment, this may result in a target requirement that, within a tolerance range TOL1 of ± 20%, ± 10% or less, e.g., ± 5% a phase at post main amplifier input match phase plane PHPL6 a phase of + 90° is present when compared to a post peak amplifier input match phase plane PHPL4 which may be represented as:

$$PHPL6 - PHPL4 = + 90° \pm TOL1$$

The term input may relate to an example left side of the Main amplifier when viewing Fig. 5 whilst not limiting the embodiments with respect to terms like right, left, upper or lower or the like as those terms may arbitrarily change when rotating an object in space. Likewise, this may hold for the peak path,

With the assumption that the phase shift of phase correction network 46 being $\Phi_1$ and a phase shift of the peak driver input matching network 38, being labeled as $\Phi_{1a}$, a phase shift introduced by the peak driver amplifier 54 may be labeled as $\Phi_{1b}$. Within a tolerance range TOL2 of at most ± 25°, ± 15°, or at most ± 5°, $\Phi_{1b}$ may equal 180°.

A phase shift introduced by peak amplifier input matching network $38_4$ is labeled as $\Phi_{1c}$ and a phase shift obtained at the input of the coupler main amplifier path is labeled as $\Phi_{0a}$. similarly, a phase shift introduced at the main amplifier input matching network 38, is labeled as $\Phi_{0b}$.

Between PHPL5 and PHPL0 there is introduced the phase shift of the distribution network 12 to the main path. Between PHPL1 and PHPL0, there is introduced the phase shift of PCN 46 compensating or absorbing a phase shift that is introduced by the distribution network 12 into the peak path to allow, within tolerances, that a phase is correct at plane PHPL1.

At PHPL6 there is, thus, introduced and starting from a reference phase plane PHPL0 at the input of distribution network 12 the phase shift $\Phi_{0a}$ and the phase shift $\Phi_{0b}$ resulting in

$$\text{Each PHPL6} = \text{PHPL0} + \Phi_{0a} + \Phi_{0b}$$

Further, for the post peak amplifier input match phase plane PHPL4, it may be obtained

$$\text{PHPL4} = \text{PHPL0} + \Phi_1 + \Phi_{1a} + \Phi_{1b} + \Phi_{1c}$$

In view of the target requirement to have PHPL6 - PHPL4 = + 90° within the tolerance range TOL1 there may be obtained

$$(\Phi 0a + \Phi 0b) - (\Phi 1 + \Phi 1a + \Phi 1b + \Phi 1c) = +90° \pm \text{TOL1}$$

$$(\Phi 0a + \Phi 0b) - (\Phi 1 + \Phi 1a - 180° \pm \text{TOL2} + \Phi 1c) = +90° \pm \text{TOL1}$$

The phase shift introduced by the peak driver input matching network 38, may separate the post first PCN phase plane PHPL1 from the post peak driver input match phase plane PHPL2. The phase shift introduced by the peak driver amplifier 54 labeled as $\Phi_{1b}$ may separate the post peak driver input match phase plane PHPL2 from the post peak driver amplifier phase plane PHPL3. The phase shift introduced by the peak amplifier input matching network $38_4$ may separate the post peak driver amplifier phase plane PHPL3 from the post peak amplifier input match phase plane PHPL4. With regard to the phase shift introduced by the phase correction network 46, same may be adopted according to the remaining requirements shown in equation RB11. According to one embodiment, the phase correction network 46 may be configured to essentially adapt the phase of the received signal by 90° within a tolerance range of, e.g., $\pm$ 25°, $\pm$ 15°, or $\pm$ 5°.

Embodiments described in connection with Fig. 1 through Fig. 5 exemplarily show an inverted Doherty-type amplifier device having a main path and a single peak path. However, the present disclosure is not limited to inverted Doherty-type amplifier devices with a single peak path. According to embodiments, at least a second peak path may be implemented resulting in a three-way inverted Doherty-type amplifier device or an inverted Doherty-type amplifier device of increased order. According to an embodiment, the distribution network of the inverted Doherty-type amplifier device comprises at least a third output port configured to provide a third signal for a second peak path of the inverted Doherty-type amplifier device. A third phase correction network may be coupled to the third signal port and is configured to adjust a phase of a received signal to obtain a phase corrected third signal. An amplifier such as a third amplifier may be coupled to an output of the third phase correction network and may be configured to amplify a received signal, e.g., based on the phase corrected third signal such as the phase corrected third signal itself, to obtain a phase corrected third amplified signal. The inverted Doherty-type amplifier device may comprise a phase correction network coupled to an output of the amplifier of the second peak path and configured to adjust a phase of a received signal to obtain a phase corrected third amplified signal that may be provided to the signal combiner. The phase corrected third amplified signal may be adjusted with regard to its phase with respect to the main path and/or the first peak path.

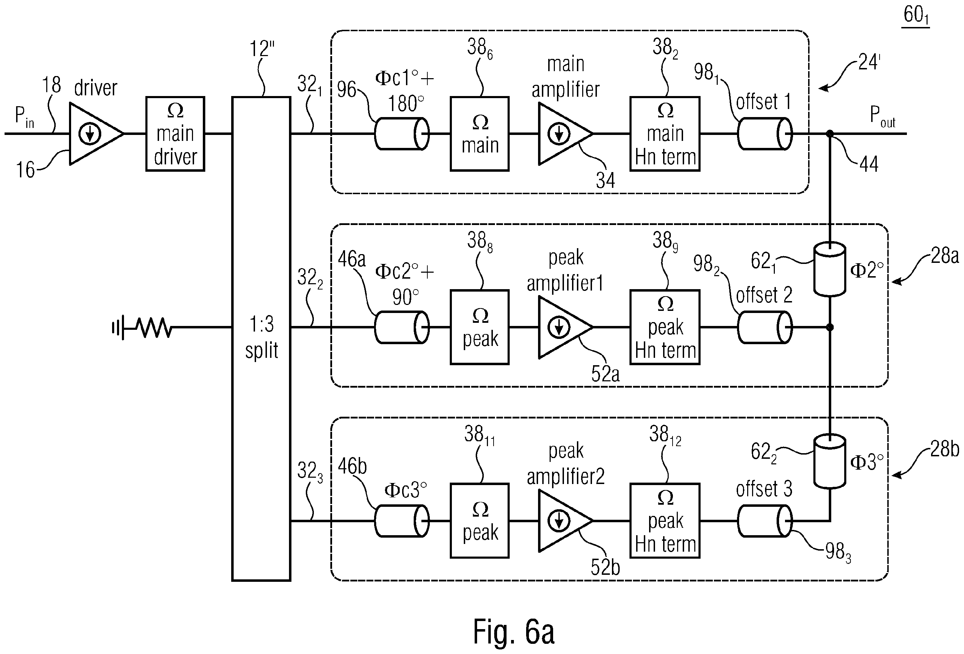

Fig. 6a shows a schematic block diagram of an inverted Doherty-type amplifier device $60_1$ according to an embodiment having a first peak path 28a and at least a second peak path 28b. a distribution network 12" may be implemented, for example, as a signal splitter having at least three output ports $32_1$, $32_2$, and $32_3$. Signal port $32_1$ may be coupled to a main path 24' that has, when compared to the main path 24 of Fig. 1, a phase compensation network 96 coupled between the port $32_1$ and the amplifier $38_2$ to correct or adapt a phase. For example, the phase correction network 96 may provide for 180° phase shift and additionally $\Phi_c 1°$. It is to be noted that the phase shift $\Phi_c 1°$ may deviate from the phase shift of $\Phi_{1c}°$ in Fig. 5 as $\Phi_c 1°$ is possibly more complex due to the different splitter/combiner implementation. The index "c" may represent a correction. What is corrected are phase impairments which are absorbed in the matching components and/or the transistor stages themselves, which are, in the three way inverted Doherty implementation different when compared to a two way inverted Doherty implementation.

Further, the mentioned network 38, may be coupled to another matching network $38_6$, both serially coupled with each other and between the phase correction network 96 and the amplifier $38_2$. The main path 24' may comprise an additional matching network $38_7$ as well as a phase offset $98_1$ coupled between an output of the amplifier 38 next to and the signal combiner 44. The additional matching of phase correction network 96 and offset $98_1$ as well as other elements may be adapted to the target to compensate for additional phase shifts being obtained by the distribution network 12'' so as to allow for a corresponding phase of the outputs of the main path 24' and the peak paths 28a and 28b.

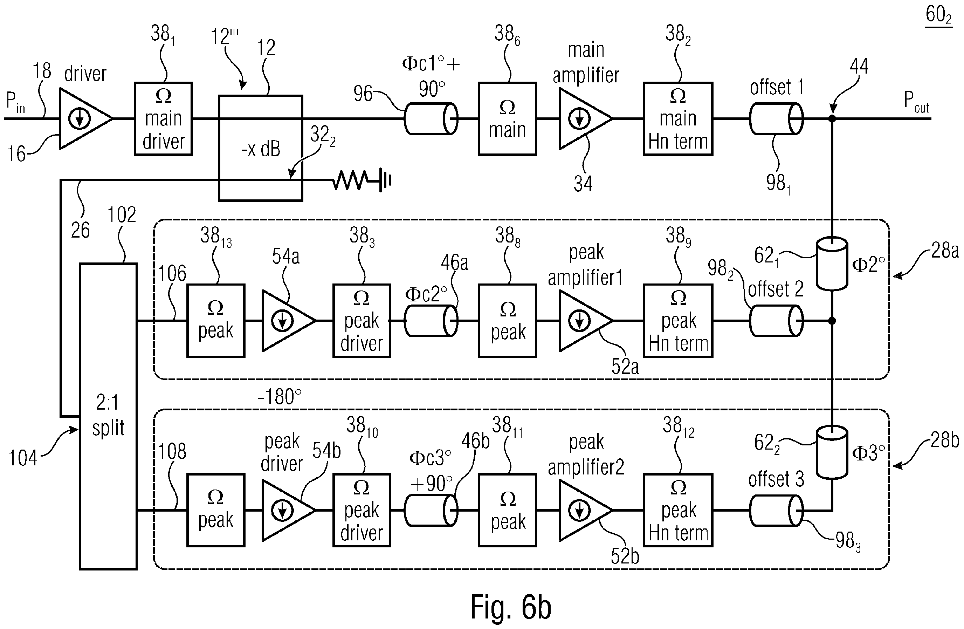

Fig. 6b shows a schematic block diagram of an inverted Doherty-type amplifier device $60_2$ according to an embodiment being implemented as a 3-way inverted Doherty-type amplifier device, wherein when compared to the inverted Doherty-type amplifier device $60_1$ the distribution network 12''' comprises a coupler, e.g., the distribution network 12 shown in Fig. 1 and a splitter 102 having an input 104 coupled to the output port $32_2$ of the distribution network 12 to obtain input signals 106 and 108 for the peak paths 28a and 28b. Phase correction networks 46a and 46b are coupled, by way of non-limiting example and different to the inverted Doherty-type amplifier device $60_1$ between a respective output of a driver 54a, 54b respectively and an input of amplifiers 52a, 52b respectively.

The phase offsets implemented in the main path and peak paths 28a and 28b may be adapted to allow for a corresponding phase received at the signal combiner 44.

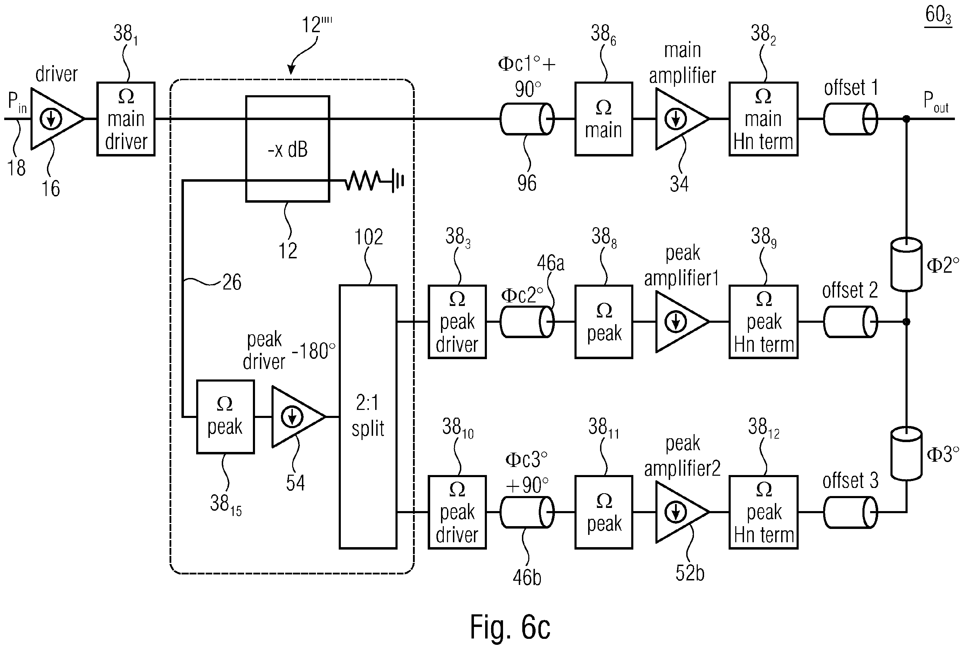

Fig. 6c shows a schematic block diagram of an inverted Doherty-type amplifier device $60_3$ according to an embodiment. Therein, a distribution network 12'''' comprises the peak driver 54 coupled between the distribution network or coupler 12 and the input of the splitter 102 to amplify signal 26, thereby combining the function of drivers 54a and 54b of inverted Doherty-type amplifier device $60_2$. Similarly, matching networks $38_{13}$ and $38_{14}$ of inverted Doherty-type amplifier device $60_2$ may be combined to a matching network $38_{15}$.

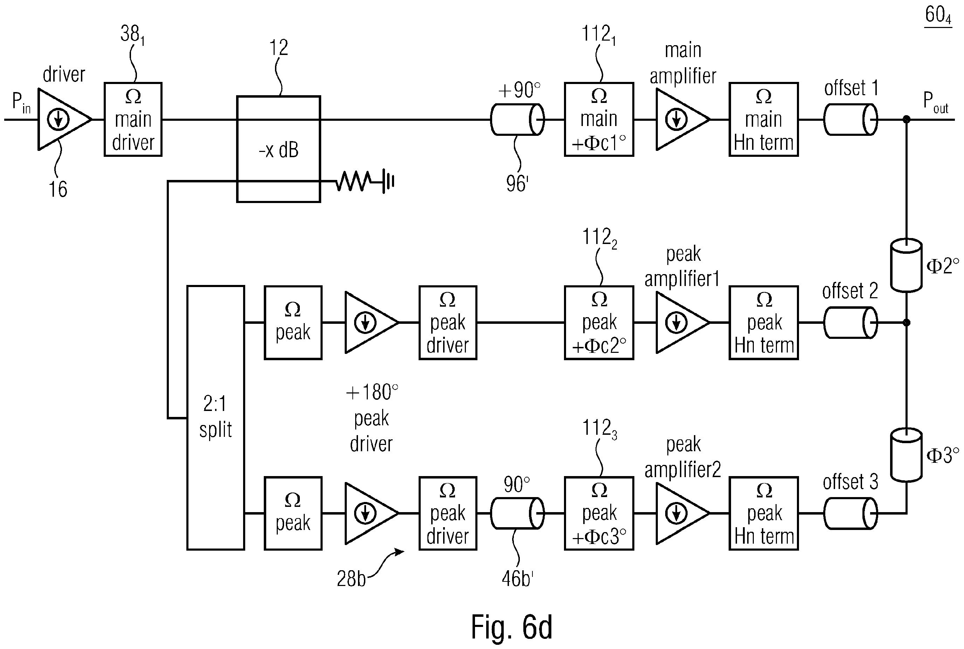

Fig. 6d shows a schematic block diagram of an inverted Doherty-type amplifier device $60_4$ that represents a variation of the inverted Doherty-type amplifier device $60_2$ of Fig. 6b. Therein, the output matching block 38, is combined or connected to the RF driver 16, e.g., between an output of driver 16 and an input of the distribution network 12. Alternatively or in addition, fine phase corrections $\Phi_{c1}$, $\Phi_{c2}$ and $\Phi_{c3}$ of phase correction networks 96, 46a and 46b of inverted Doherty-type amplifier device $60_2$ may be combined with matching networks $38_6$, $38_8$, and $38_{11}$, or may be absorbed by the input matching networks as matching circuitry $112_1$, $112_2$, $112_3$ respectively. As may be seen in peak path 28b, a phase correction network 46b' providing for, e.g., 90° phase shift, whilst the fine tuning of $\Phi_{c3}$ is moved to a different block, may be arranged in a changed order when compared to Fig. 6b.

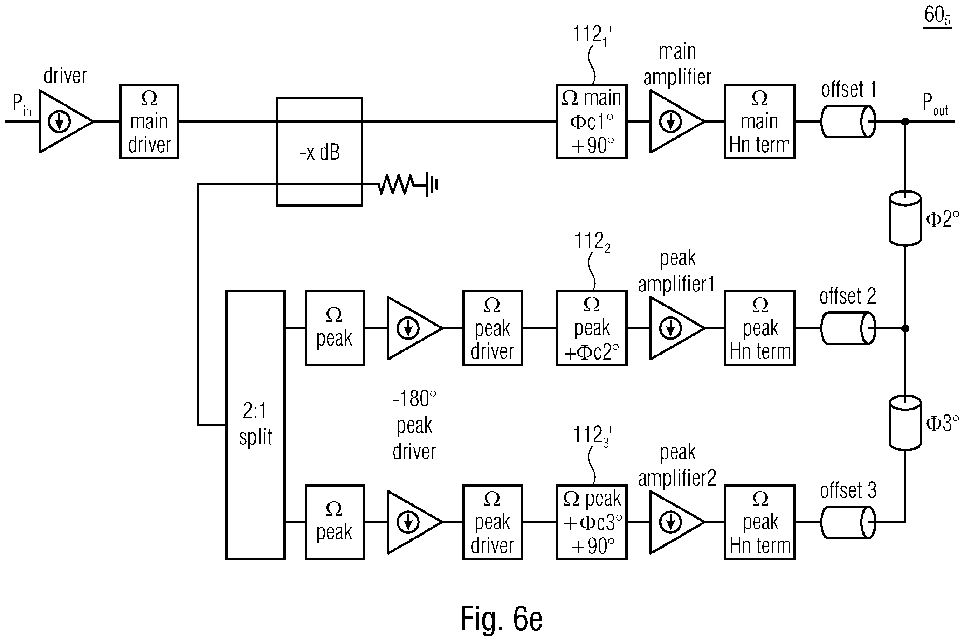

Fig. 6e shows a schematic block diagram of an inverted Doherty-type amplifier device $60_5$ that is a modification of inverted Doherty-type amplifier device $60_4$ of Fig. 6d. Therein, the 90° phase shifts of phase correction networks 96' of the main path, 46b' of peak path 28b may be combined with the matching circuitry $112_1$ to arrive at a matching circuitry $112_1$' and with the matching circuitry $112_3$ to arrive at a matching circuitry $112_3$'. Thus, the functional block illustrated in the schematic block diagrams described herein may, from a functional view, also be combined with each other without limiting the scope of the underlying disclosure.

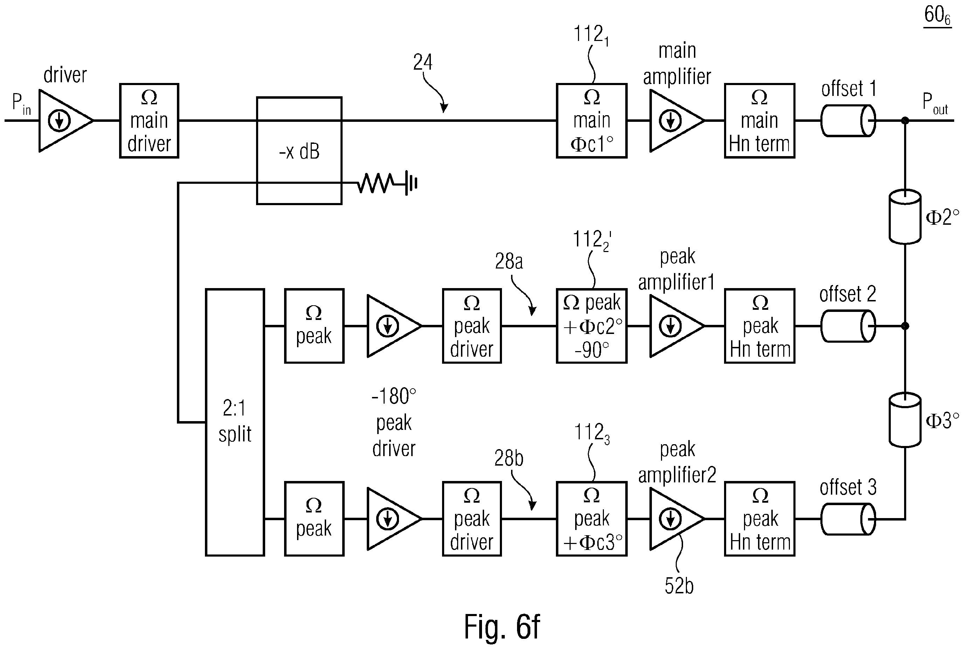

Fig. 6f shows a schematic block diagram of an inverted Doherty-type amplifier device $60_6$ according to an embodiment in which the respective phase shifts of matching networks or matching circuitries $112_1$, $112_2$ and $112_3$ or of $112_1$', $112_2$ and $112_3$' of Fig. 6d or Fig. 6e are adapted to have the phase adaptation to be implemented in peak paths 28a and 28b. When compared to Fig. 6d, the main path 24 may have the matching circuit $112_1$ whilst the phase shift implemented by phase correction network 96' is implemented in peak path 28a as a negative phase shift of -90° in matching circuitry $112_2$'. This allows to have phase correction network 46b' of Fig. 6b implemented in the matching circuitry $112_2$' accordingly such that another 90° phase shift in peak path 28b at the input of amplifier 52b may be unrequired. That is, the phase correction network of a peak path, according to an embodiment, may be implemented in the matching circuitry $112_2$'.

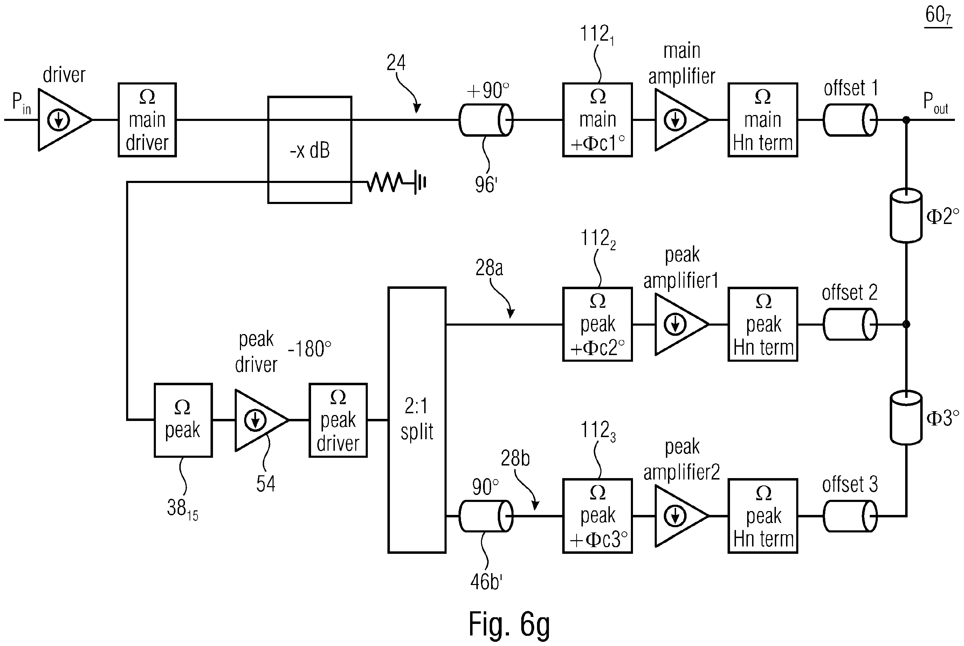

Fig. 6g shows a schematic block diagram of an inverted Doherty-type amplifier device $60_7$ according to an embodiment that implements a modification when compared to the inverted Doherty-type amplifier device $60_3$ of Fig. 6c. Compared thereto, and similar to the modification implemented in Fig. 6d when compare to Fig. 6b, fine corrections $\Phi_{c1}$, $\Phi_{c2}$, $\Phi_{c3}$, respectively, may be combined with the matching networks 38, and $38_6$ in the main path, with the matching networks $38_3$ and 38s for peak path 28a and with matching networks $38_{10}$ and $38_{11}$ in peak path 28b. This may allow to implement phase change networks 96' and 46e' as delay lines of 90° with low complexity.

That is, although not showing a phase correction network in peak path 28a, the function thereof and, thus, the phase correction is still implemented. When compared to the implementation of Fig. 6c, the output matching blocks $\Omega$ main driver and $\Omega$ peak driver are moved directly to the RF driver blocks. Further, the fine phase corrections $\Phi_{c1}$, $\Phi_{c2}$, and $\Phi_{c3}$, may be individually, as a group, or globally, be absorbed by the respective input matching network of the main amplifier, the peak amplifier of the first peak path or the peak amplifier of the second peak path.

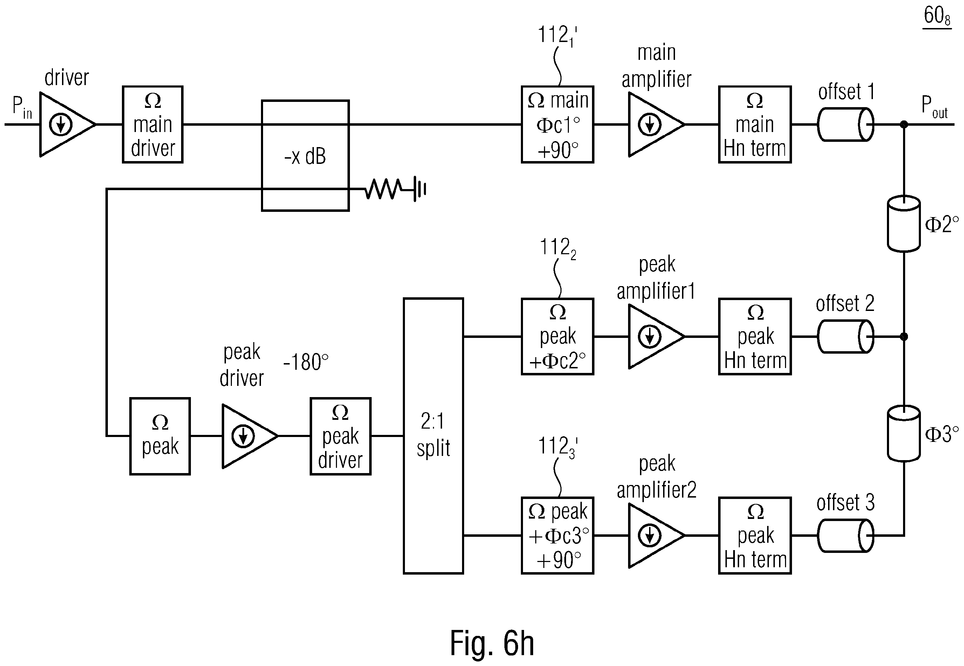

Fig. 6h shows a schematic block diagram of an inverted Doherty-type amplifier device $60_8$ according to an embodiment. Therein, when compared to the inverted Doherty-type amplifier device $60_7$ of Fig. 6g, the phase correction network 96' may be combined with matching circuitry $112_1$ to arrive at an adapted matching circuitry $112_1$'. Similarly,

the phase correction network 46b' may be combined with the matching circuitry $112_3$ to arrive at a modified matching circuitry $112_3$'. The modification implemented may be similar to the implementation between Fig. 6d and Fig. 6e and may be implemented individually for the main path and for the peak path 28b, i.e., in only one of both paths or in both paths. Thus, the 90° phase shifts in the main path and the second peak path may be absorbed by the input matching networks of the main amplifier and the peak amplifier of the second peak path.

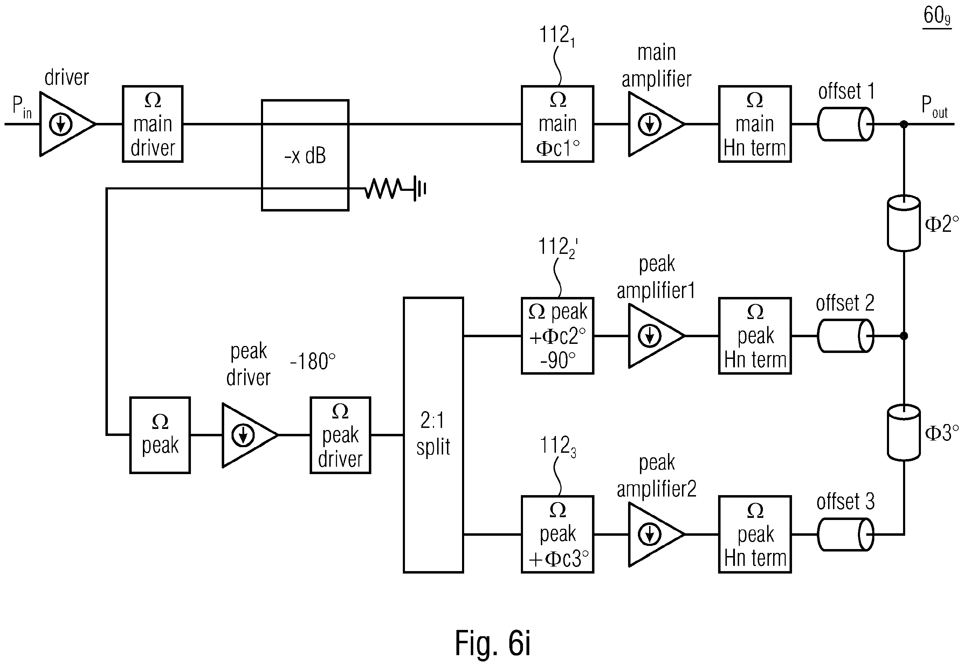

Fig. 6i shows a schematic block diagram of an inverted Doherty-type amplifier device $60_9$ according to an embodiment that is modified when compared to the inverted Doherty-type amplifier device $60_8$ by implementing the relative phase shifts of the main path and the second peak path with regard to the first peak path by implementing the respective phase change in a modified matching circuitry $112_2$' whilst still fine tuning in matching circuitries $112_1$ in the main path and $112_3$ in the second peak path. That is, the changed input matching networks of the main amplifier, the peak amplifier of the first peak path and the peak amplifier of the second peak path may be changed such that a phase offset of -90° is reached for all three paths.

Referring again to Fig. 3a-f and in particular Fig. 3a showing an example Wilkinson Coupler and to Fig. 3c and Fig. 3f showing a lumped hybrid coupler, a hybrid coupler respectively, a distribution network may be implemented differently whilst staying in accordance with embodiments described herein. For example, different distribution networks may allow for different advantages or levels thereof such that different use cases of an embodiment may allow to select a different distribution network. For example, a non-flat response of a coupler in either phase or amplitude over a frequency range might be used to correct a non-flat phase / amplitude response of the inverted Doherty-type amplifier stages.

Alternatively or in addition, to obtain a flat response of the amplifier stages, a more flat input coupler may be useful. Alternatively or in addition, the implementation may have an impact on at least one of a size and cost, which may contribute to an overall optimization criteria and which may lead to choosing one over the other input Coupler version. Such criteria may, as a further alternative or in addition, vary for different designs of an inverted Doherty-type amplifier devices described herein, leading to a certain degree of freedom within the design.

For example, with regard to a Wilkinson amplifier, same may advantageously provide for a phase offset and a phase correction and a flat amplitude response along with a non-flat phase response in a phase offset path. When operating the Wilkinson Coupler to provide for symmetric power when comparing the peak path and the main path, a matched termination may be used. Alternatively, a reactive termination may be used to allow a use of the reflections. When operating the Wilkinson Coupler with asymmetric power, also a matched termination or a reactive termination may used, the reactive termination allowing to use reflections for equalizing / boosting a gain of the main path.

For example, when using a hybrid coupler to form at least a part of the distribution network, the hybrid coupler may allow for a phase correction along with a non-flat amplitude response for the benefit of a flat phase response. Similar to the Wilkinson Coupler, a matched or a reactive termination may be used. When operating at symmetric power output, a reactive termination may allow to use reflections for equalizing / boosting a gain of the main path.

For example, when using a directional coupler to form at least a part of the distribution network, the directional coupler may allow for a phase offset and/or a phase correction along with a non-flat amplitude response. Similar to the Wilkinson Coupler and/or the hybrid coupler, a matched termination or a reactive termination may be used. A reactive termination may allow to use reflections for equalizing / boosting a gain of the main path.

According to the embodiments described in connection with Fig. 6a through Fig. 6i, a signal splitter of an inverted Doherty-type amplifier may be coupled between the distribution network and the amplifier of the peak path such that an input of the signal splitter is coupled to the signal port $32_2$ of the distribution network 12. The signal splitter may be configured to split the signal 25 into a first portion 106 and a second portion 108 and to provide the respective portion 106 and 108 at a respective output. The inverted Doherty-type amplifier device comprises at least a second peak path to receive the second portion, wherein a reference between the peak paths 28a and 28b may be changed without limitation. A phase correction network, e.g., the phase correction network 46b or 46b', the combined version in matching circuitry $112_3$ or $112_3$' may be coupled to the second output port of the signals data and configured to adjust a phase of a received signal, e.g., based on the second portion 108, e.g., the signal itself or a matched version thereof and/or an amplifier version thereof, to obtain a phase corrected third signal. An amplifier 52b may be coupled to an output of the phase correction network 46b or the respective circuitry and may provide for a phase corrected third amplified signal based on the received signal. A phase correction network $62_2$ and/or $98_3$ may be coupled to an output of the amplifier 52b to provide for a phase corrected third amplifier signal that is adjusted with respect to the main path and/or the first peak path. With reference to Fig. 6b, for example, phase correction networks $62_2$ and $98_3$ may be combined with one another as may phase correction network $98_2$ and $62_1$. When combining phase correction networks $98_2$ and $62_1$, the resulting circuitry may also be connected directly to the combiner 44, whereby possibly changing the phase shifts implemented in elements $98_3$, $62_2$ and/or $62_1$.

According to an embodiment, a driver circuit may be coupled between the distribution network and the signal splitter as shown, for example, in Fig. 6c and the variance thereof represented in Fig. 6g through Fig. 6i.

According to an embodiment, the distribution network used to split the input signal 14 may comprise a third signal port for providing an third signal as illustrated, for example, in connection with the splitter of Fig. 6a. A phase correction network of the second peak path, e.g., phase correction network $98_3$ and/or $62_2$ may be coupled between the amplifier 52b and the phase correction network $98_2$ or $62_1$.

According to an embodiment, phase correction networks of the peak paths 28a and 28b, e.g., $98_3$, e.g., in combination with $62_2$ and $98_2$, e.g., in combination with $62_1$ may provide for a same phase correction when compared to each other. This phase correction may be 90° within a tolerance range of, e.g., ± 25°, ± 15°, or ± 5°.

The use of two or more peak paths allows for further increasing efficiency. For example, another peak portion of the signal received in the peak path may be subjected to the second peak path and the like. In return for the increased complexity of the circuitry obtained an increase in efficiency.

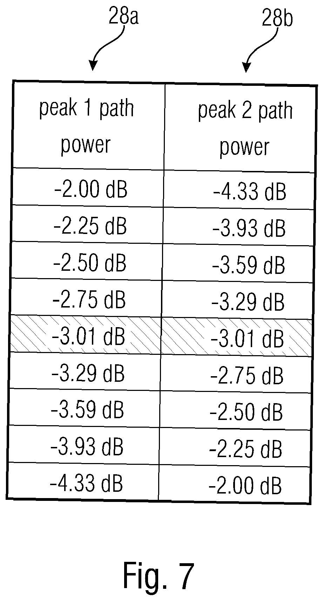

Fig. 7 represents an example table of possible split ratios between peak path 28a and peak path 28b that may be generated, for example, by use of splitter 102. As may be seen, each of both paths 28a and 28b may receive a same power (- 3 dB) when compared to the other, more power or less.

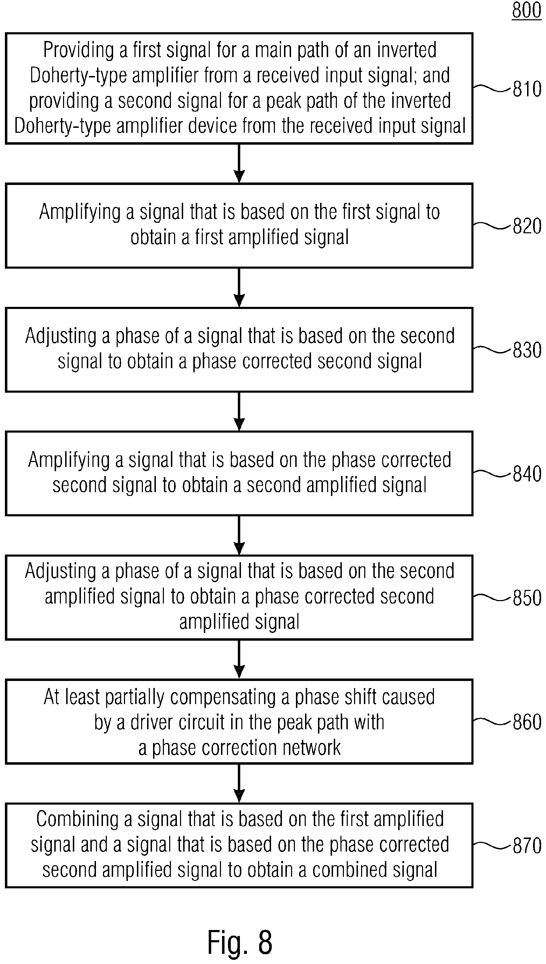

Fig. 8 shows a schematic block diagram of a method 800 according to an embodiment. A step 810 comprises providing a first signal for a main path of an inverted Doherty-type amplifier from a received input signal and providing a second signal for a peak path of the inverted Doherty-type amplifier device from the received input signal. Such an inverted Doherty-type amplifier device may be any device in accordance with the present disclosure.

A step 820 comprises amplifying a signal that is based on the first signal to obtain a first amplified signal. A step 830 comprises adjusting a phase of a signal that is based on the second signal to obtain a phase corrected second signal. A step 840 comprises amplifying a signal that is based on the phase corrected second signal to obtain a second amplified signal.

A step 850 comprises adjusting a phase of a signal that is based on the second amplified signal to obtain a phase corrected second amplified signal. A step 860 comprises at least partially compensating a phase shift caused by a driver circuit in the peak path with a phase correction network.

A step 870 comprises combing a signal that is based on the first amplified signal and a signal that is based on the second phase corrected second amplified signal to obtain a combined signal.

Embodiments of the present disclosure provide for a solution to operating devices such as radio heads in a more efficient region that allows to reduce the effort of cooling the radio head. Provided systems with more efficient power amplifiers require smaller efforts for passive or active cooling of the antenna array resulting in smaller and less weight of the equipment, which is even less expensive and which eases the requirements to the construction. By increasing the power added efficiency PAE of each power amplifier in an antenna array radio head, the system cost can be reduced significantly and, based thereon, a $CO_2$ emission footprint of a base station may be reduced.

To achieve this, implementations of a dedicated RF driver for the peak amplifier path in an inverted Doherty-type power amplifier device core may allow the inverted Doherty power amplifier system to weigh more input power to the main amplifier of a Doherty system, overcoming a natural drawback of a lack of gain in a Doherty core. As a result, the system PAE is increasing. This system measure may be important to maintain a high gain of the power amplifier especially if the semiconductor process for the transistors reach their physical limits for gain, which is the case for high power and high frequencies.

According to some aspects related to the present disclosure, an inverted Doherty RF power amplifier may comprise a driver amplifier followed by an RF splitter, e.g., using a split ratio of -3 dB/-3 dB up to -1.5 dB/-5.35 dB, wherein the main branch amplifier may be biased in class AB (F-1) to operate over the whole RF envelope (dynamics), the second branch, the peak path, may be biased in a class C mode to kick in at high levels of the envelope to source the peak power. The two branches may be combined such that the peak changes the load (decreasing the load impedance) for the main stage such that at higher power envelope levels the main amplifier stage is still in its high efficient region. Since the peak amplifier is biased, according to some aspects, in class C, its gain may be lower than the gain of the main stage which is possibly biased in class AB. The way out provided by the presented embodiments is to allocate more RF power from the splitter to the peak amplifier than to the main amplifier. The drawback that the main amplifier experiences lower gain due to the unfavorable power split which manifests in a significant efficiency penalty over the signal envelope statistics may be addressed, according to embodiments, by implementing a split ratio that provides more power to the main path than to the peak path, e.g., -0.5 dB to the main path and - 10dB to the peak path. Embodiments relate to add a dedicated peak driver amplifier to compensate the significant loss in the peak path. That causes a phase inversion in the peak path. Therefore, embodiment provide for an inverted Doherty architecture according to embodiments described herein provide for a phase correction network and the losses caused thereby to include into the peak path such that the losses of this block are present in the path which is less relevant for the system PAE, the peak path. This allows to mitigate the lack of RF gain of an RF transistor technology.

Embodiments thus provide for a high gain in the main path that results in a high system PAE. Embodiments also allow for a relaxed need for cooling which can result in equipment that consumes less energy at a lower cost.

A conventional Doherty amplifier architecture is changed, by use of the described embodiments, into an inverted Doherty power amplifier with a strong asymmetric splitting ratio at the Doherty core input. This may increase the gain in the efficiency relevant main path. To compensate the lack of gain in the peak path, a dedicated driver may be added to the peak path which may enable to move off the phase correction network from the main path to the peak path due to phase inversion. Keeping the main path as high gain as possible may enable the system to operate at high system efficiency for complex modulated signals with high peak average ratio, PAR.

**[0087]** Embodiments of the present disclosure are described hereinafter in other words.

A first aspect of the present disclosure relates to an inverted Doherty-type amplifier device comprising:

a distribution network (12) comprising a first signal port ($32_1$) for providing a first signal (22) for a main path (24) of the inverted Doherty-type amplifier from a received input signal; and comprising a second signal port ($32_2$) for providing a second signal (26) for a peak path (28) of the inverted Doherty-type amplifier device from the received input signal;

a first amplifier (34) coupled in the main path (24) and coupled to the first signal port ($32_1$), configured to amplify a received signal to obtain a first amplified signal;

a first phase correction network (46) coupled to the second signal port ($32_2$) and configured to adjust a phase of a received signal to obtain a phase corrected second signal (48);

a second amplifier (52), coupled to an output of the first phase correction network (46) and configured to amplify a received signal to obtain a second amplified signal;

a second phase correction network (62) coupled to an output of the second amplifier (52) and configured to adjust a phase of a received signal to obtain a phase corrected second amplified signal;

a driver circuit (54) in the peak path, wherein the first phase correction network (46) is adapted to at least partially compensate for a phase shift caused by the driver circuit (54);

a signal combiner (44) having a first input ($66_1$) coupled to an output of the first amplifier (34); and having a second input ($66_2$) coupled to an output of the second phase correction network (62), the signal combiner (44) configured to combine a signal that is based on the first amplified signal and a signal that is based on the phase corrected second amplified signal to obtain a combined signal (68).

A second aspect of the present disclosure relates to the inverted Doherty-type amplifier device according to claim 1, wherein the first phase correction network (46) is configured to essentially adapt the phase of the received second signal (26) by 90° within a tolerance range.

A third aspect of the present disclosure relates to the inverted Doherty-type amplifier device according to aspect 1 or 2, wherein the distribution network (12) comprises one of an unequal lumped Wilkinson splitter, a lumped coupler and a lumped hybrid coupler.

A fourth aspect of the present disclosure relates to the inverted Doherty-type amplifier device according to one of the previous aspects, wherein the distribution network (12) is configured to provide the first signal (22) having a higher power level as the second signal (26).

A fifth aspect of the present disclosure relates to the inverted Doherty-type amplifier device according to one of the previous aspects, wherein the distribution network (12) is configured to provide the first signal (22) having a split ratio of approximately at least -1.25 dB and at most -0.5 dB and the second signal (26) having a split ratio of approximately at least -14 dB and at most -6 dB.

A sixth aspect of the present disclosure relates to the inverted Doherty-type amplifier device according to one of the previous aspects, wherein the second phase correction network (62) is configured to provide a phase shift of essentially 90°.

A seventh aspect of the present disclosure relates to the inverted Doherty-type amplifier device according to one of the previous aspects, wherein the first amplifier (34) is a class AB amplifier.

A eighth aspect of the present disclosure relates to the inverted Doherty-type amplifier device according to one of previous aspects, wherein the second amplifier (52) is a class C amplifier.

A ninth aspect of the present disclosure relates to the inverted Doherty-type amplifier device according to one of the previous aspects, wherein the peak path (28) is a first peak path (28a); wherein the distribution network (12) comprises at least a third output port configured to provide a third signal (108) for a second peak path (28b) of the inverted Doherty-type amplifier device; wherein the inverted Doherty-type amplifier device comprises:

a third phase correction network (46b) coupled to the third signal port and configured to adjust a phase of a received signal to obtain a phase corrected third signal; and

a third amplifier (52b) coupled to an output of the third phase correction network (46b) and configured to amplify a received signal to obtain a phase corrected third amplified signal;

wherein the inverted Doherty-type amplifier device comprises a fourth phase correction network coupled to an output of the third amplifier and configured to adjust a phase of a received signal to obtain a phase corrected third amplified signal coupled to the signal combiner (44).

An tenth aspect of the present disclosure relates to the inverted Doherty-type amplifier device according to one of the previous aspects, wherein the peak path (28) is a first peak path (28a);

wherein the inverted Doherty-type amplifier device comprises a signal splitter (102) coupled between the distribution network (12) and the second amplifier (52);

wherein the signal splitter (12′′′) comprises an input coupled to the second signal port ($32_2$) of the distribution network (12); wherein the signal splitter (102) is configured to split the second signal (26) into a first portion (106) and a second portion (108); wherein the signal splitter (102) comprises a first output configured to provide the first portion (106) and a second output configured to provide the second portion (108), the first output of the signal splitter (102) coupled to the second amplifier (52);

wherein the inverted Doherty-type amplifier device comprises at least a second peak path (28b) to receive the second portion; wherein the inverted Doherty-type amplifier device comprises:

a third phase correction network (46b) coupled to the second output port of the signal splitter (102) and configured to adjust a phase of a received signal to obtain a phase corrected third signal; and

a third amplifier coupled in the second peak path (28b), coupled to an output of the third phase correction network (46b) and configured to amplify a received signal to obtain a phase corrected third amplified signal;

wherein the Doherty-type amplifier device comprises a fourth phase correction network coupled to an output of the third amplifier and configured for adjusting a phase of a received signal to obtain a phase corrected third amplified signal that is provided to the signal combiner.

An eleventh aspect of the present disclosure relates to the inverted Doherty-type amplifier device according to aspect 10, wherein the inverted Doherty-type amplifier device comprises a driver circuit (54) coupled between the distribution network (12) and the signal splitter.
A twelfth aspect of the present disclosure relates to the inverted Doherty-type amplifier device according to one of aspects 1 to 9, wherein the peak path (28) is a first peak path (28a); wherein the distribution network (12) comprises a third signal port for providing a third signal for a second peak path (28b) of the inverted Doherty-type amplifier device from the received input signal;
wherein a third phase correction network (46b) is coupled between a third amplifier (52b) of the second peak path (28b) and the second phase correction network (62).
A thirteenth aspect of the present disclosure relates to the inverted Doherty-type amplifier device according to aspect 12, wherein a fourth phase correction network coupled between the first signal port ($32_1$) and the first amplifier (34) provides for a same phase correction when compared to first phase correction network (46), e.g., approximately 90°.
A fourteenth aspect of the present disclosure relates to a method (800) for amplifying a signal, the method comprising:

providing (810) a first signal for a main path of an inverted Doherty-type amplifier from a received input signal; and providing a second signal for a peak path of the inverted Doherty-type amplifier device from the received input signal;

amplifying (820) a signal that is based on the first signal to obtain a first amplified signal;

adjusting (830) a phase of a signal that is based on the second signal to obtain a phase corrected second signal;

amplifying (840) a signal that is based on the phase corrected second signal to obtain a second amplified signal;

adjusting (850) a phase of a signal that is based on the second amplified signal to obtain a phase corrected second amplified signal; and

at least partially compensating (860) a phase shift caused by a driver circuit in the peak path with a phase correction network;

combining (870) a signal that is based on the first amplified signal and a signal that is based on the phase corrected second amplified signal to obtain a combined signal.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The above described embodiments are merely illustrative for the principles of the present disclosure. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

**Claims**

1. An inverted Doherty-type amplifier device comprising:

   a distribution network (12) comprising a first signal port ($32_1$) for providing a first signal (22) for a main path (24) of the inverted Doherty-type amplifier from a received input signal; and comprising a second signal port ($32_2$) for providing a second signal (26) for a peak path (28) of the inverted Doherty-type amplifier device from the received input signal;
   a first amplifier (34) coupled to the first signal port ($32_1$) and configured to amplify a received signal to obtain a first amplified signal;
   a first phase correction network (46) coupled to the second signal port ($32_2$) and configured to adjust a phase of a received signal to obtain a phase corrected second signal (48);
   a second amplifier (52), coupled to an output of the first phase correction network (46) and configured to amplify a received signal to obtain a second amplified signal;
   a second phase correction network (62) coupled to an output of the second amplifier (52) and configured to adjust a phase of a received signal to obtain a phase corrected second amplified signal;
   a driver circuit (54) in the peak path, wherein the first phase correction network (46) is adapted to at least partially compensate for a phase shift caused by the driver circuit (54);
   a signal combiner (44) having a first input ($66_1$) coupled to an output of the first amplifier (34); and having a second input ($66_2$) coupled to an output of the second phase correction network (62), the signal combiner (44) configured to combine a signal that is based on the first amplified signal and a signal that is based on the phase corrected second amplified signal to obtain a combined signal (68).

2. The inverted Doherty-type amplifier device according to claim 1, wherein the first phase correction network (46) is configured to essentially adapt the phase of the received second signal (26) by 90° within a tolerance range.

3. The inverted Doherty-type amplifier device according to claim 1 or 2, wherein the distribution network (12) comprises one of an unequal lumped Wilkinson splitter, a lumped coupler and a lumped hybrid coupler.

4. The inverted Doherty-type amplifier device according to one of the previous claims, wherein the distribution network (12) is configured to provide the first signal (22) having a higher power level as the second signal (26).

5. The inverted Doherty-type amplifier device according to one of the previous claims, wherein the distribution network (12) is configured to provide the first signal (22) having a gain of at least -1.25 dB and at most -0.5 dB and the second signal (26) having a split ratio of approximately at least -14 dB and at most -6 dB.

6. The inverted Doherty-type amplifier device according to one of the previous claims, wherein the second phase correction network (62) is configured to provide a phase shift of essentially 90°.

7. The inverted Doherty-type amplifier device according to one of the previous claims, wherein the first amplifier (34) is a class AB amplifier.

8. The inverted Doherty-type amplifier device according to one of previous claims, wherein the second amplifier (52) is a class C amplifier.

9. The inverted Doherty-type amplifier device according to one of the previous claims, wherein the peak path (28) is a first peak path (28a); wherein the distribution network (12) comprises at least a third output port configured to provide a third signal (108) for a second peak path (28b) of the inverted Doherty-type amplifier device; wherein the inverted Doherty-type amplifier device comprises:

   a third phase correction network (46b) coupled to the third signal port and configured to adjust a phase of a received signal to obtain a phase corrected third signal; and
   a third amplifier (52b) coupled to an output of the third phase correction network (46b) and configured to amplify a received signal to obtain a phase corrected third amplified signal;
   wherein the inverted Doherty-type amplifier device comprises a fourth phase correction network coupled to an output of the third amplifier and configured to adjust a phase of a received signal to obtain a phase corrected third amplified signal coupled to the signal combiner (44).

10. The inverted Doherty-type amplifier device according to one of the previous claims, wherein the peak path (28) is a first peak path (28a);

   wherein the inverted Doherty-type amplifier device comprises a signal splitter (102) coupled between the distribution network (12) and the second amplifier (52);
   wherein the signal splitter (12‴) comprises an input coupled to the second signal port ($32_2$) of the distribution network (12); wherein the signal splitter (102) is configured to split the second signal (26) into a first portion (106) and a second portion (108); wherein the signal splitter (102) comprises a first output configured to provide the first portion (106) and a second output configured to provide the second portion (108), the first output of the signal splitter (102) coupled to the second amplifier (52);
   wherein the inverted Doherty-type amplifier device comprises at least a second peak path (28b) to receive the second portion; wherein the inverted Doherty-type amplifier device comprises:

   a third phase correction network (46b) coupled to the second output port of the signal splitter (102) and configured to adjust a phase of a received signal to obtain a phase corrected third signal; and
   a third amplifier coupled in the second peak path (28b), coupled to an output of the third phase correction network (46b) and configured to amplify a received signal to obtain a phase corrected third amplified signal;
   wherein the Doherty-type amplifier device comprises a fourth phase correction network coupled to an output of the third amplifier and configured for adjusting a phase of a received signal to obtain a phase corrected third amplified that is provided to the signal combiner.

11. The inverted Doherty-type amplifier device according to claim 10, wherein the inverted Doherty-type amplifier device comprises a driver circuit (54) coupled between the distribution network (12) and the signal splitter.

12. The inverted Doherty-type amplifier device according to one of claims 1 to 8, wherein the peak path (28) is a first peak path (28a); wherein the distribution network (12) comprises a third signal port for providing a third signal for a second peak path (28b) of the inverted Doherty-type amplifier device from the received input signal;
   wherein a third phase correction network (46b) is coupled between a third amplifier (52b) of the second peak path (28b) and the second phase correction network (62).

13. The inverted Doherty-type amplifier device according to claim 12, wherein a fourth phase correction network coupled between the first signal port ($32_1$) and the first amplifier (34) provides for a same phase correction when compared to first phase correction network (46), e.g., approximately 90°.

14. Method (800) for amplifying a signal, the method comprising:

   providing (810) a first signal for a main path of an inverted Doherty-type amplifier from a received input signal; and providing a second signal for a peak path of the inverted Doherty-type amplifier device from the received input signal;

amplifying (820) a signal that is based on the first signal to obtain a first amplified signal;

adjusting (830) a phase of a signal that is based on the second signal to obtain a phase corrected second signal;

amplifying (840) a signal that is based on the phase corrected second signal to obtain a second amplified signal;

adjusting (850) a phase of a signal that is based on the second amplified signal to obtain a phase corrected second amplified signal; and

at least partially compensating (860) a phase shift caused by a driver circuit in the peak path with a phase correction network;

combining (870) a signal that is based on the first amplified signal and a signal that is based on the phase corrected second amplified signal to obtain a combined signal.

Fig. 1

Fig. 2

EP 4 456 419 A1

Fig. 3a

Fig. 3b

Fig. 3c

$84_4$

$92_1$    $92_3$    $32_1$

88    $\lambda/4$    $\lambda/4$

$Z_{0A}$    $Z_{0C}$

$R_W$

$Z_{0B}$    $Z_{0D}$

$\lambda/4$    $\lambda/4$

$92_2$    $92_4$    $32_2$

94    46

90°    Φc1°

## Fig. 3d

$32_1$    $84_5$

$92_1$    TERM

$92_2$

88    $32_2$

## Fig. 3e

$32_1$    $84_6$

$92_1$    TERM

$92_2$

88    $32_2$

## Fig. 3f

| peak path power | main path power |
|---|---|
| -6.00 dB | -1.26 dB |
| -7.00 dB | -0.97 dB |
| -8.00 dB | -0.75 dB |
| -9.00 dB | -0.58 dB |
| -10.00 dB | -0.46 dB |
| -11.00 dB | -0.36 dB |
| -12.00 dB | -0.28 dB |
| -13.00 dB | -0.22 dB |
| -14.00 dB | -0.18 dB |

Fig. 4

Fig. 5

Fig. 6a

Fig. 6b

EP 4 456 419 A1

Fig. 6c

Fig. 6d

EP 4 456 419 A1

Fig. 6e

EP 4 456 419 A1

Fig. 6f

EP 4 456 419 A1

Fig. 6g

$60_8$

Fig. 6h

Fig. 6i

28a        28b

| peak 1 path power | peak 2 path power |
|---|---|
| -2.00 dB | -4.33 dB |
| -2.25 dB | -3.93 dB |
| -2.50 dB | -3.59 dB |
| -2.75 dB | -3.29 dB |
| -3.01 dB | -3.01 dB |
| -3.29 dB | -2.75 dB |
| -3.59 dB | -2.50 dB |
| -3.93 dB | -2.25 dB |
| -4.33 dB | -2.00 dB |

# Fig. 7

800

```
┌─────────────────────────────────────────────────┐
│ Providing a first signal for a main path of an   │
│ inverted Doherty-type amplifier from a received  │
│ input signal; and providing a second signal for  │──810
│ a peak path of the inverted Doherty-type         │
│ amplifier device from the received input signal  │
└─────────────────────────────────────────────────┘
                        │
                        ▼
┌─────────────────────────────────────────────────┐
│ Amplifying a signal that is based on the first   │
│ signal to obtain a first amplified signal        │──820
└─────────────────────────────────────────────────┘
                        │
                        ▼
┌─────────────────────────────────────────────────┐
│ Adjusting a phase of a signal that is based on   │
│ the second signal to obtain a phase corrected    │──830
│ second signal                                    │
└─────────────────────────────────────────────────┘
                        │
                        ▼
┌─────────────────────────────────────────────────┐
│ Amplifying a signal that is based on the phase   │
│ corrected second signal to obtain a second       │──840
│ amplified signal                                 │
└─────────────────────────────────────────────────┘
                        │
                        ▼
┌─────────────────────────────────────────────────┐
│ Adjusting a phase of a signal that is based on   │
│ the second amplified signal to obtain a phase    │──850
│ corrected second amplified signal                │
└─────────────────────────────────────────────────┘
                        │
                        ▼
┌─────────────────────────────────────────────────┐
│ At least partially compensating a phase shift    │
│ caused by a driver circuit in the peak path with │──860
│ a phase correction network                       │
└─────────────────────────────────────────────────┘
                        │
                        ▼
┌─────────────────────────────────────────────────┐
│ Combining a signal that is based on the first    │
│ amplified signal and a signal that is based on   │──870
│ the phase corrected second amplified signal to   │
│ obtain a combined signal                         │
└─────────────────────────────────────────────────┘
```

Fig. 8

Europäisches
Patentamt

European
Patent Office

Office européen
des brevets

# EUROPEAN SEARCH REPORT

Application Number

EP 23 17 0711

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/026583 A1 (YANDURU NAVEEN [US] ET AL) 25 January 2018 (2018-01-25) | 1-4,6-8, 14 | INV. H03F1/02 H03F3/19 H03F3/21 |
| Y | * paragraph [0003] – paragraph [0085]; figures 1-3 * | 5 | H03F3/24 |
| | ----- | | H03F3/60 |
| X | US 2018/013391 A1 (MAALOUF ELIE A [US] ET AL) 11 January 2018 (2018-01-11) | 1-4, 6-10, 12-14 | |
| Y | * paragraph [0013] – paragraph [0076]; | 5 | |
| A | figures 1-5 * | 11 | |
| | ----- | | |
| X | US 2017/359032 A1 (MCLAREN ROY [US]) 14 December 2017 (2017-12-14) | 1-4, 6-10, 12-14 | |
| A | * paragraph [0031] – paragraph [0084]; figures 2,3 * | 5,11 | |
| | ----- | | |
| A | US 2003/201833 A1 (PENGELLY RAYMOND SYDNEY [US] ET AL) 30 October 2003 (2003-10-30) * paragraph [0026] – paragraph [0030]; figures 2,3 * | 10 | |
| | ----- | | TECHNICAL FIELDS SEARCHED (IPC) |
| Y | US 11 245 363 B2 (MACOM TECH SOLUTIONS HOLDINGS INC [US]) 8 February 2022 (2022-02-08) * column 7; figure 8 * | 5 | H03F |
| | ----- | | |

The present search report has been drawn up for all claims

| Place of search | Date of completion of the search | Examiner |
|---|---|---|
| The Hague | 28 September 2023 | Sípal, Vít |

EPO FORM 1503 03.82 (P04C01)

**EP 4 456 419 A1**

## ANNEX TO THE EUROPEAN SEARCH REPORT
## ON EUROPEAN PATENT APPLICATION NO.

EP 23 17 0711

This annex lists the patent family members relating to the patent documents cited in the above-mentioned European search report.
The members are as contained in the European Patent Office EDP file on
The European Patent Office is in no way liable for these particulars which are merely given for the purpose of information.

28-09-2023

| Patent document cited in search report | | | Publication date | Patent family member(s) | | | Publication date |
|---|---|---|---|---|---|---|---|
| US 2018026583 | A1 | | 25-01-2018 | NONE | | | |
| US 2018013391 | A1 | | 11-01-2018 | CN | 107395129 | A | 24-11-2017 |
| | | | | EP | 3247038 | A1 | 22-11-2017 |
| | | | | US | 9774301 | B1 | 26-09-2017 |
| | | | | US | 2018013391 | A1 | 11-01-2018 |
| | | | | US | 2020144968 | A1 | 07-05-2020 |
| US 2017359032 | A1 | | 14-12-2017 | CN | 107493075 | A | 19-12-2017 |
| | | | | EP | 3255788 | A1 | 13-12-2017 |
| | | | | US | 9667199 | B1 | 30-05-2017 |
| | | | | US | 2017359032 | A1 | 14-12-2017 |
| US 2003201833 | A1 | | 30-10-2003 | CA | 2516302 | A1 | 18-11-2004 |
| | | | | CN | 1780762 | A | 31-05-2006 |
| | | | | EP | 1620325 | A2 | 01-02-2006 |
| | | | | JP | 5425238 | B2 | 26-02-2014 |
| | | | | JP | 2006525749 | A | 09-11-2006 |
| | | | | JP | 2012075193 | A | 12-04-2012 |
| | | | | KR | 20060008991 | A | 27-01-2006 |
| | | | | TW | 200501559 | A | 01-01-2005 |
| | | | | US | 2003201833 | A1 | 30-10-2003 |
| | | | | WO | 2004100215 | A2 | 18-11-2004 |
| US 11245363 | B2 | | 08-02-2022 | CN | 110785927 | A | 11-02-2020 |
| | | | | EP | 3616319 | A1 | 04-03-2020 |
| | | | | TW | 201842729 | A | 01-12-2018 |
| | | | | US | 2020382069 | A1 | 03-12-2020 |
| | | | | US | 2022131503 | A1 | 28-04-2022 |
| | | | | WO | 2018197918 | A1 | 01-11-2018 |

EPO FORM P0459

For more details about this annex : see Official Journal of the European Patent Office, No. 12/82